Europäisches Patentamt

European Patent Office

Office européen des brevets

(11) Veröffentlichungsnummer: **0 269 566**
B1

(12) **EUROPÄISCHE PATENTSCHRIFT**

(45) Veröffentlichungstag der Patentschrift:
13.06.90

(51) Int. Cl.⁵: **B65G 47/91,** B65G 59/04,
H05K 13/00

(21) Anmeldenummer: 87810635.0

(22) Anmeldetag: 04.11.87

(54) **Transportvorrichtung für perforierte plattenförmige Objekte.**

(30) Priorität: 10.11.86  CH 4480/86

(43) Veröffentlichungstag der Anmeldung:
01.06.88 Patentblatt 88/22

(45) Bekanntmachung des Hinweises auf die Patenterteilung:
13.06.90 Patentblatt 90/24

(84) Benannte Vertragsstaaten:
CH DE FR GB IT LI NL SE

(56) Entgegenhaltungen:
US-A- 2 841 433
US-A- 3 602 543

(73) Patentinhaber: Haas-Laser Systems AG,
Pumpwerkstrasse 23, CH-8105 Regensdorf(CH)

(72) Erfinder: Marzinotto, Francesco, Wehntalerstrasse 176,
CH-8057 Zürich(CH)

(74) Vertreter: Marx, Lothar, Dr. et al, Patentanwälte
Schwabe, Sandmair, Marx
Stuntzstrasse 16 Postfach 86 02 45,
D-8000 München 80(DE)

## Beschreibung

Die Erfindung betrifft eine Vorrichtung gemäss Oberbegriff des Anspruchs 1.

In der Elektronik-Industrie kommt es vielfach vor, dass auf einem Stapel befindliche Leiterplatten Stück für Stück vom Stapel abgenommen und der weiteren Bearbeitung oder Verwendung zugeführt werden müssen. Ueblicherweise werden dazu mehr oder weniger automatisierte Transportvorrichtungen verwendet, die in der Regel mit einem Greiferkopf ausgestattet sind, welcher die Platten mittels Saugwirkung festhält. Bei perforierten Leiterplatten kommt es dabei aber insofern zu Schwierigkeiten, als oftmals nicht nur die oberste Platte allein, sondern gleichzeitig zwei oder mehrere Platten vom Stapel abgehoben werden.

Durch die Erfindung soll nun dieses Problem überwunden und eine Transportvorrichtung und ein Transportverfahren der zur Rede stehenden Gattung dahingehend verbessert werden, dass auch im Falle von perforierten Platten ein einwandfreies Abnehmen einzelner Platten von einem Stapel gewährleistet ist. Insbesondere soll dies auf konstruktiv möglichst einfache und kostengünstige Weise erreicht werden.

Diese der Erfindung zugrunde liegende Aufgabe ist durch die im Anspruch 1 angeführten Merkmale gelöst. Besonders zweckmässige Ausgestaltungen ergeben sich jeweils aus den abhängigen Ansprüchen.

Gemäss dem Grundgedanken der Erfindung werden also die Perforationen des zu haltenden bzw. zu transportierenden Objekts mittels spezieller Dichtnoppen im Bereich des Greiferkopfs abgedichtet. Dadurch kann sich die Saugwirkung nicht auf die darunterliegenden Objekte ausdehnen, und das zuoberst auf dem Stapel befindliche Objekt kann daher problemlos allein vom Stapel abgenommen werden.

In der US-A-3602543 die dem Oberbegriff des Anspruchs 1 entspricht, ist ein Vakuum-Greifer für Lasten beschrieben, welche im Angriffsbereich des Greifers eine durchgehende Oeffnung aufweisen. Der Greifer ist mit einer Dichtplatte ausgestattet, die eine Reihe von konzentrischen Dichtlippen trägt. In Betrieb liegen diese Dichtlippen an der zu hebenden Last an und umschliessen dessen Oeffnung, sodass diese abgedichtet wird. Dieser bekannte Greifer mag für Lasten mit einem oder einigen wenigen, relativ grossen Oeffnungen geeignet sein, für den Transport von Leiterplatten mit ihren vielen kleinen Perforationen wäre eine solche Konstruktion jedoch kaum brauchbar bzw. machbar und ausserden viel zu aufwendig. Ueberdies wird das der Erfindung zugrundeliegende Problem in dieser Druckschrift überhaupt nicht angesprochen.

Ein weiterer Vakuum-Greifer ist in US-A-2841433 beschrieben. Dieser weist eine Reihe von vorhangartigen, an ihren unteren Enden mit Dichtorganen versehenen Klappen auf und ist dazu bestimmt, Kartons, Schachteln und dergleichen von Paletten oder Transportbändern abzuheben. Für den Transport von Leiterplatten und die damit zusammenhängenden Spezialprobleme ist dieser Greifer ebenfalls nicht geeignet.

Weitere Vakuum-Greifer sind in US-A-3523707, JP-A-57-145723 und FR-A-2184072 beschrieben. Diesen Greifern ist gemeinsam, dass sie in eine Reihe von Kammern aufgeteilt sind, deren jede über ein mehr oder weniger ausgeklügeltes Verteilsystem mit der Vakuum-Quelle verbunden ist. Diese Greifer sind relativ kompliziert und für perforierte Leiterplatten offensichtlich ungeeignet oder zumindest zu aufwendig.

Im folgenden wird die erfindung anhand der Zeichnung näher erläutert. Es zeigen:

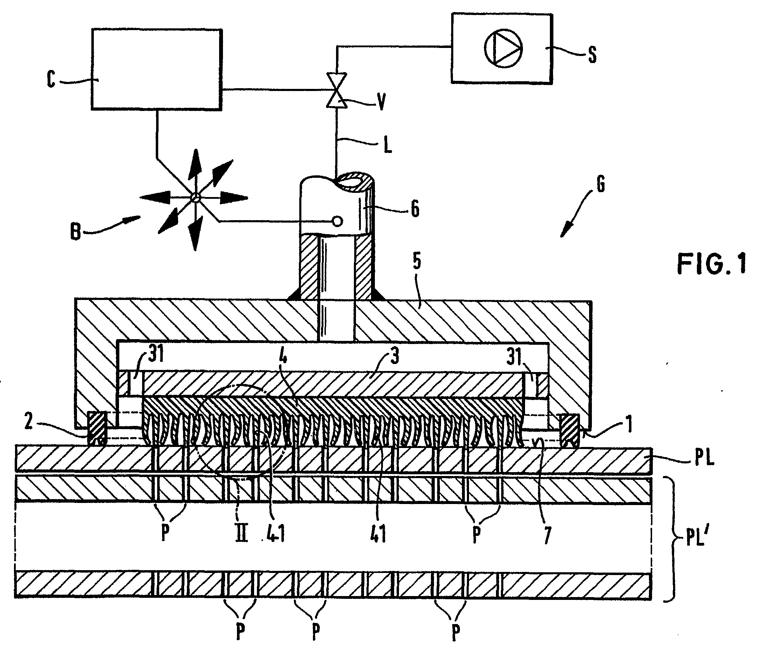

Fig. 1 eine schematische Ansicht der erfindungsgemässen Vorrichtung in teilweise geschnittener Darstellung und
Fig. 2 und 3 Detailausschnitte aus Fig. 1 in vergrösserter Darstellung.

Die dargestellte Transportvorrichtung umfasst im wesentlichen einen glockenförmigen Greiferkopf G, eine mit diesem über eine flexible, ein Absperrventil V enthaltende Leitung L verbundene Saugvorrichtung S, eine hier nur symbolisch durch Pfeile angedeutete Bewegungsvorrichtung B für den Greiferkopf G und eine Steuereinheit C zur Steuerung der Bewegungsabläufe und des Absperrventils.

Der Greiferkopf G besitzt die Gestalt eines nach unten offenen Bechers mit hier z.B. quadratischem Querschnitt. In den Rand 1 des Greiferkopfs ist eine umlaufende elastische Dichtungslippe 2 eingelassen, mittels welcher der Greiferkopf G auf dem zu greifenden Objekt dicht anliegt. Im Inneren des Greiferkopfs G ist etwa parallel zum Oeffnungsrand 1 eine Trägerplatte 3 und auf dieser eine elastische Noppenmatte 4 angeordnet. Am Rand der Trägerplatte 3 sind ringsum Luftdurchtrittsöffnungen 31 vorgesehen, welche die beiden durch die Trägerplatte 3 getrennten Hohlräume des Greiferkopfs verbinden. Der Deckel 5 des Greiferkopfs weist einen Anschluss 6 für die flexible Verbindungsleitung L zur Saugvorrichtung S auf.

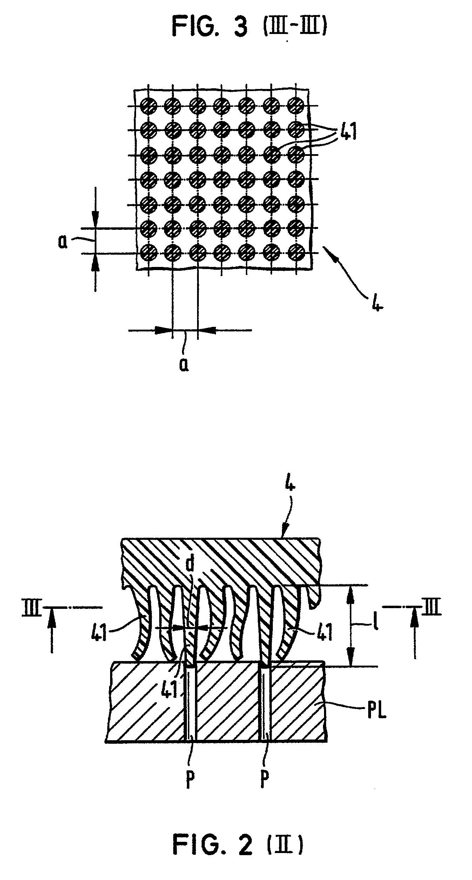

Die Noppenmatte 4 besteht aus einem elastichen Kunstoff und weist an ihrer Unterseite eine Vielzahl von borstenartigen elastischen Noppen 41 auf. Die Länge 1 der Noppen 41 beträgt etwa 3 bis 8 mm, vorzugsweise etwa 4 bis 6 mm. Der (mittlere) Durchmesser d der Noppen 41 beträgt etwa 0,4 bis 1,5 mm, vorzugsweise etwa 0,8 bis 1,2 mm. Der gegenseitige Abstand a der einzelnen Noppen ist so gewählt, dass auf den Quadratzentimeter etwa 20 bis 150, vorzugsweise 50 bis 100 Noppen kommen (Fig. 2 und 3).

Die Noppen 41 ragen in der Praxis bis etwa zu der durch die umlaufende Dichtlippe 2 definierten Ebene 7 vor oder etwas über diese Ebene hinaus.

Im Betrieg dringen diese Noppen dann, wenn der Greifkopf G auf die vom Stapel abzunehmende Leiterplatte PL aufgesetzt wird, in die Perforationen P derselben ein und verschliessen sie. Die Noppenmatte 4 bildet also eine Dichtungseinrichtung zum Verschliessen der Perforationen des zu haltenden Objekts.

Dadurch, dass die Perforationen P der obersten Leiterplatte PL verschlossen werden, kann sich die Saugwirkung nicht durch diese Perforationen hindurch auf die darunter liegenden Leiterplatten PL' fortsetzen und die oberste Leiterplatte kann daher problemlos vom Stapel abgehoben werden.

Die Bewegung des Greiferkopfs G und das Aktivieren und Desaktivieren der Saugwirkung erfolgen in an sich bekannter Weise unter der Kontrolle der Steuerung C.

Vorstehend wurde die Erfindung lediglich im Zusammenhand mit perforierten Leiterplatten erläutert. Selbstverständlich ist die erfindungsgemässe Transportvorrichtung auch zum Transport von anderen perforierten Platten oder anderen Objecten geeignet.

## Patentansprüche

1. Transportvorrichtung zum einzelnen Abheben von mit einer Vielzahl von Perforationen versehenen plattenförmigen Objekten, im speziellen gebohrten Leiterplatten, von einem Stapel solcher Objekte, mit einem an eine Saugvorrichtung anschliessbaren, im wesentlichen glockenförmigen Greiferkopf (G) und einer Anordnung (C, B) zur Steuerung des Greiferkopfs, welcher an seiner dem zu haltenden Objekt (PL) zugewandten, offenen Seite mit einer Dichtungseinrichtung (4) zum Schliessen wenigstens eines Teils der Perforationen (P) des Objekts (PL) versehen ist, dadurch gekennzeichnet, dass die Dichtungseinrichtung (4) an ihrer dem Objekt (PL) zugewandten Seite eine Vielzahl von elastischen Noppen (41) aufweist, deren Durchmesser (d) so auf die Perforation (P) abgestimmt ist, dass sie beim Aufsetzen des Greiferkopfes (G) auf das vom Stapel abzuhebende Objekt (PL) in die Perforationen (P) eindringen und diese dabei dicht verschliessen.

2. Vorrichtung nach Anspruch 1, dadurch gekennzeichnet, dass die Dichtungseinrichtung (4) im wesentlichen plattenförmig ausgebildet ist und die offene Seite des Greiferkopfs (G) wenigstens teilweise verschliesst.

3. Vorrichtung nach Anspruch 2, dadurch gekennzeichnet, dass die Noppen (41) aus der offenen Seite (7) des Greiferkopfs (G) herausragen.

4. Vorrichtung nach einem der Ansprüche 1 bis 3, dadurch gekennzeichnet, dass die Noppen (41) leicht konisch ausgebildet sind.

5. Vorrichtung nach einem der Ansprüche 1 bis 4, dadurch gekennzeichnet, dass die Noppen (41) einen mittleren Durchmesser von etwa 0,4 bis 1,5, vorzugsweise 0,8 bis 1,2 mm besitzen.

6. Vorrichtung nach einem der Ansprüche 1 bis 5, dadurch gekennzeichnet, dass die Noppen (41) etwa 3 bis 8 mm, vorzugsweise 4 bis 6 mm lang sind.

7. Vorrichtung nach einem der Ansprüche 1 bis 6, dadurch gekennzeichnet, dass der Greiferkopf (G) im Bereich seines die offene Seite umschliessenden Rands (1) mit einer elastischen Dichtungslippe (2) versehen ist.

8. Vorrichtung nach einem der Ansprüche 1 bis 7, dadurch gekennzeichnet, dass die Noppen (41) an einer elastischen Matte (4) ausgebildet sind, die auf einem Träger (3) befestigt ist.

9. Vorrichtung nach einem der Ansprüche 1 bis 8, dadurch gekennzeichnet, dass zwischen der Matte (4) bzw. dem Träger (3) und der Seitenwandung (1) des Greiferkopfs (G) Luftdurchtrittsöffnungen (31) vorgesehen sind.

10. Vorrichtung nach einem der Ansprüche 1 bis 9, dadurch gekennzeichnet, dass pro cm$^2$ etwa 20 bis 150, vorzugsweise 50 bis 100 Noppen (41) vorgesehen sind.

## Claims

1. A transport device for the individual lifting-off of plate-shaped objects, particularly drilled circuit boards, provided with a plurality of perforations, from a stack of such objects, with a substantially bellshaped gripper head (G) which can be connected to a suction means and an arrangement (C, B) for controlling the gripper head, which is provided at its open side facing the object (PL) to be held with a sealing device (4) for closing at least part of the perforations (P) of the object (PL), characterised in that the sealing device (4) has on its side facing the object (PL) a plurality of elastic finger(s) (41), the diameter (d) of which is matched to the perforations (P) in such a manner that upon placing the gripper head (G) on the object (PL) which is to be lifted from the stack they penetrate into the perforations (P) and in doing so close them tightly.

2. A device according to Claim 1, characterised in that the sealing device (4) is substantially plate-shaped and at least partially closes the open side of the gripper head (G).

3. A device according to Claim 2, characterised in that the finger(s) (41) extend out of the open side (7) of the gripper head (G).

4. A device according to one of Claims 1 to 3, characterised in that the finger(s) (41) are slightly conical.

5. A device according to one of Claims 1 to 4, characterised in that the finger(s) (41) have a mean diameter of approximately 0.4 to 1.5, preferably 0.8 to 1.2, mm.

6. A device according to one of Claims 1 to 5, characterised in that the finger(s) (41) are approximately 3 to 8 mm, preferably 4 to 6 mm, long.

7. A device according to one of Claims 1 to 6, characterised in that the gripper head (G) is provided with an elastic sealing lip (2) in the region of its edge (1) enclosing the open side.

8. A device according to one of Claims 1 to 7, characterised in that the finger(s) (41) are formed on an elastic mat (4) which is secured to a support (3).

9. A device according to one of Claims 1 to 8, characterised in that air passages (31) are provided between the mat (4) or the support (3) and the side wall (1) of the gripper head (G).

10. A device according to one of Claims 1 to 9, characterised in that approximately 20 to 150, preferably 50 to 100, finger(s) (41) are provided per cm$^2$.

## Revendications

1. Dispositif de transport pour soulever isolément, d'une pile de ces objets, des objets en forme de plaquettes présentant un grand nombre de perforations, en particulier des plaquettes conductrices perforées, dispositif comportant un tête (G) de pince sensiblement en forme de cloche et raccordable à un dispositif de mise sous vide, ainsi qu'un système (C, B) pour commander la tête de pince, laquelle est munie, sur sa face ouverte, tournée vers l'objet (PL) à saisir, d'un organe (4) d'étanchéité pour obturer au moins une partie des perforations (P) de l'objet (PL), dispositif caractérisé en ce que l'organe d'étanchéité présente, sur sa face tournée vers l'objet (PL), un grand nombre de poils (41) élastiques dont le diamètre (d) est adapté aux perforations (P) de façon telle que, lorsque l'on pose la tête (G) de pince sur l'objet (PL) à soulever de la pile, les poils pénètrent dans les perforations (P) et les obturent de façon étanche.

2. Dispositif selon la revendication 1, caractérisé en ce que l'organe (4) d'étanchéité a sensiblement la forme d'une plaque et obture au moins partiellement le côté ouvert de la tête (G) de pince.

3. Dispositif selon la revendication 2, caractérisé en ce que les poils (41) dépassent hors du côté ouvert (7) de la tête (G) de pince.

4. Dispositif selon l'une des revendications 1 à 3, caractérisé en ce que les poils (41) ont une forme légèrement conique.

5. Dispositif selon l'une des revendications 1 à 4, caractérisé en ce que les poils (41) ont un diamètre moyen d'environ 0,4 à 1,5, de préférence 0,8 à 1,2 mm.

6. Dispositif selon l'une des revendications 1 à 5, caractérisé en ce que les poils (41) ont une longueur d'environ 3 à 8 mm, de préférence 4 à 6 mm.

7. Dispositif selon l'une des revendications 1 à 6, caractérisé en ce que, dans la zone de son bord (1) entourant le côté ouvert, la tête (G) de pince est munie d'une lèvre (2) d'étanchéité élastique.

8. Dispositif selon l'une des revendications 1 à 7, caractérisé en ce que les poils (41) sont formés sur un tapis (4) élastique fixé à un support (3).

9. Dispositif selon l'une des revendications 1 à 8, caractérisé en ce qu'entre le tapis (4) ou le support (3) et la paroi latérale (1) de la tête (G) de pince sont prévues des ouvertures (31) de passage d'air.

10. Dispositif selon l'une des revendications 1 à 9, caractérisé en ce que, par cm², sont prévus environ 20 à 150, de préférence 50 à 100 poils (41).

FIG.1

EP 0 269 566 B1

FIG. 3 (Ⅲ-Ⅲ)

41

a

4

a

4

d

Ⅲ

41

41

41

41

l

Ⅲ

PL

P

P

FIG. 2 (Ⅱ)